(19) Europäisches Patentamt
European Patent Office
Office européen des brevets

(11) EP 1 675 181 A1

(12) **EUROPEAN PATENT APPLICATION**

(43) Date of publication:
28.06.2006 Bulletin 2006/26

(51) Int Cl.:
*H01L 27/115* (2006.01)     *H01L 21/8247* (2006.01)
*H01L 21/28* (2006.01)      *H01L 29/423* (2006.01)

(21) Application number: 04425937.2

(22) Date of filing: 22.12.2004

(84) Designated Contracting States:
AT BE BG CH CY CZ DE DK EE ES FI FR GB GR
HU IE IS IT LI LT LU MC NL PL PT RO SE SI SK TR
Designated Extension States:
AL BA HR LV MK YU

(71) Applicant: STMicroelectronics S.r.l.
20041 Agrate Brianza MI (IT)

(72) Inventors:
• **Tessariol, Paolo**
31044 Montebelluna (TV) (IT)
• **Bez, Roberto**
20146 Milano (IT)

(74) Representative: **Maccalli, Marco et al**
Maccalli & Pezzoli S.r.l.,
Via Settembrini, 40
20124 Milano (IT)

(54) **Methode of making a non-volatile MOS semiconductor memory device**

(57)     A method of making a non-volatile MOS semiconductor memory device includes a formation phase, in a semiconductor material substrate (50), of STI isolation regions (shallow trench isolation) (57) filled by field oxide (65) and of memory cells (500) separated each other by said STI isolation regions (57). The memory cells (500) include a gate electrode (52) electrically isolated from said semiconductor material substrate (50) by a first dielectric layer (53), and the gate electrode includes a floating gate (54) self-aligned to the STI isolation regions (57). The method includes a formation phase of said floating gate (54) exhibiting a substantially saddle shape including a concavity; the formation phase of said floating gate (54) includes a deposition phase of a first conformal conductor material layer (54A).

Fig.5

**Description**

The present invention relates to a method of making a semiconductor memory device.

More precisely, the present invention relates to a method of making a floating gate non-volatile MOS memory device.

Memories are devices able to store and to make accessible information stored in binary form as bits, and they can be subdivided in various categories according to the storage capacity and to the time necessary to retrieve the information stored therein.

Semiconductor memories are made in MOS (metal-oxide-semiconductor) technology on a semiconductor material substrate, typically single crystalline silicon, and are called non-volatile when they retain the information for considerable times and in absence of power supply.

Among non-volatile MOS memories, a particularly important class is that constituted by floating gate devices, in which the single cell is constituted by a MOSFET (metal-oxide-semiconductor field effect transistor) in which the gate electrode includes an additional electrode (floating gate) placed between the channel and the control electrode (control gate), completely electrically insulated from the neighbourhood and separated by a dielectric from the control gate.

The information stored in the cell is represented by the charging state of the gate electrode, that is modified by either injecting electrons from the FET into the floating gate (writing) or removing them (erasing).

In absence of relatively high voltages applied to the FET electrodes, the floating gate charge remains almost unaltered in time because the electrons remain in such electrode without disperding into the surrounding environment, thanks to the presence of insulating layers that surround its.

Among the floating gate non-volatile MOS memories, a dominant position is occupied by flash memories, whose main features are given by the possibility of being written and erased electrically, by the random access not only for reading but even for writing, and by the considerable high integration density, due to the presence of a particularly compact single transistor elementary cell.

In flash memories, the mechanism adopted for writing, or programming, a memory cell is the injection into the floating gate of "hot" electrons coming from the channel and "heated" by the application of a suitable potential difference between source and drain.

In a write operation, some ten of thousands of electrons are injected into the floating gate, and the retention thereof inside the floating gate guarantees the memory non-volatility.

The physical mechanism adopted for erasing a flash memory cell, an operation in which the floating gate substantially is emptied of the electrons injected during the writing, is the tunneling through a dielectric of the electrons from the floating gate to the source, made possible by the application of a suitable potential difference between control gate and source.

The efficiency of this charge transfer process is measured by the capacitive coupling between control gate and floating gate, that is expressed in terms of a capacitive coupling coefficient $\alpha_G$, defined as the ratio between the capacitance $C_{CG}$ of the control gate and the total capacitance $C_{TOT}$ associated with the gate electrode, that also takes into account the capacitive couplings due to the presence of the source $C_S$, of the drain $C_D$, of the tunnel oxide and of the channel $C_{FG}$ :

$$\alpha_G = C_{CG} / C_{TOT} = C_{CG} /(C_{CG} + C_{FG} + C_S + C_D).$$

According to a model widely in use, the sequence of control gate/dielectric/floating gate layers can be represented as a capacitor with plane and parallel plates separated by a dielectric, the floating gate and the control gate being the two plates thereof.

The capacitive coupling coefficient $\alpha_G$ is thus proportional to the capacitance

$$C_{CG} = \varepsilon_{diel} (A_{FG}/T_{diel})$$

where $\varepsilon_{diel}$ is the dielectric constant of the dielectric, $A_{FG}$ is the area of the floating gate surface facing the control gate, and $T_{diel}$ is the dielectric thickness.

Consequently, the capacitive coupling coefficient $\alpha_G$ strongly depends on the shape and the size of the floating gate and, in particular, it is proportional to the floating gate surface area facing the control gate.

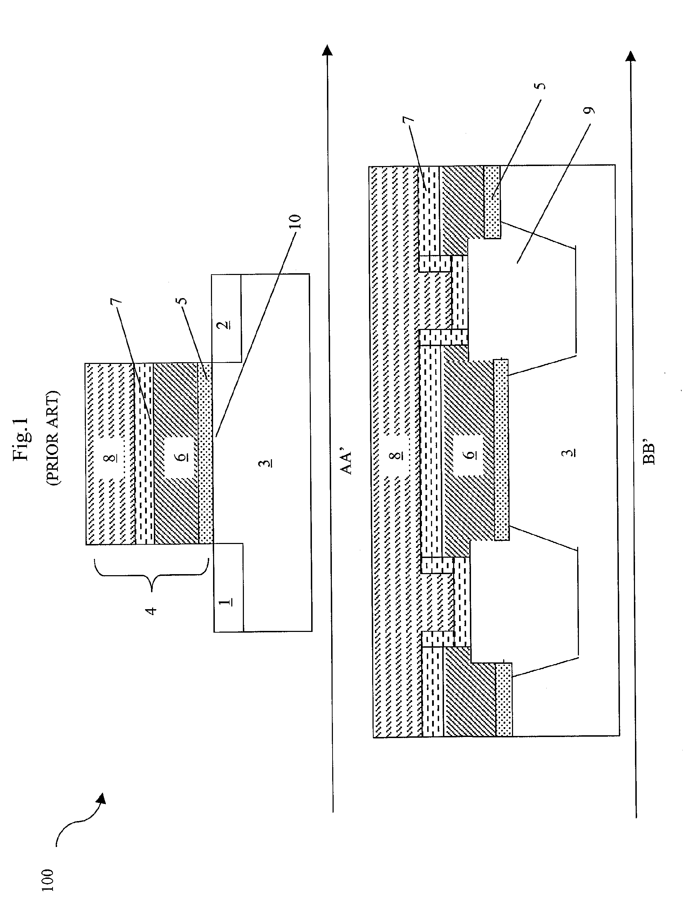

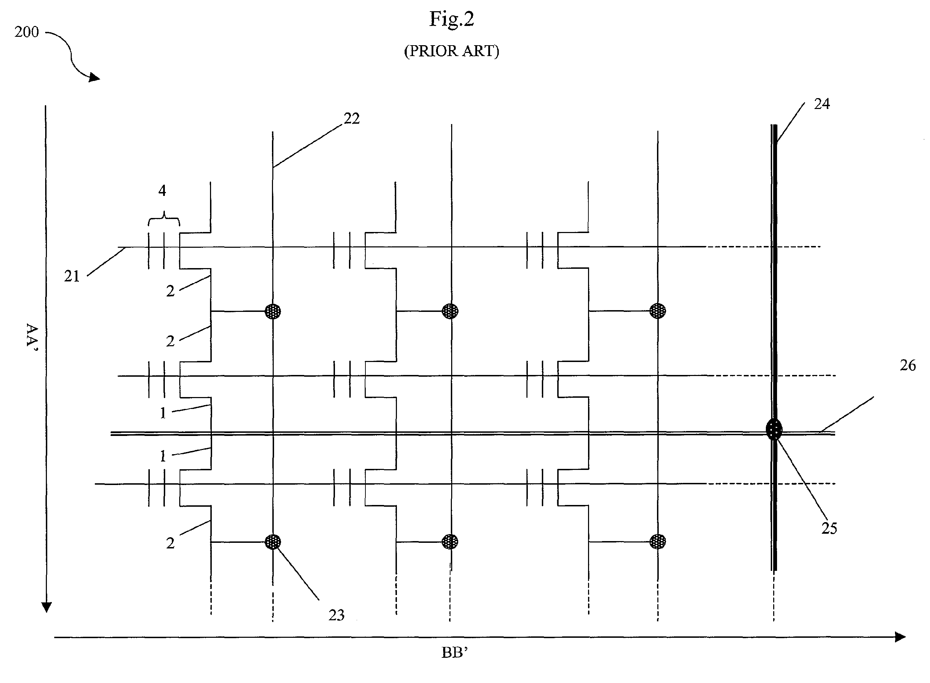

In Figures 1 and 2 there are shown, in simplified way, respectively a cross section and a circuit scheme of a portion of a matrix 200 of flash memory cells, such cross section being taken along a direction AA' and along a direction BB' perpendicular thereto.

Figure 1 evidences the layered structure of the gate electrode region 4, the wells of the source region 1 and drain region 2, and the central electrically active region 10, formed by the FET channel within a silicon single crystalline substrate 3.

Over the FET channel 10, the central region is constituted by:

● a first thin dielectric layer 5, typically silicon oxide, called tunnel oxide;

● the floating gate 6, usually formed by a heavily doped polycrystalline silicon layer;

● a second dielectric layer 7, made for example of a succession of $SiO_2/Si_3N_4/SiO_2$ thin layers called ONO (acronym for oxide-nitride-oxide), that covers the floating gate 6;

● the control gate 8, typically formed of heavily doped polycrystalline silicon layer.

Along the direction BB' the memory cells 100 are separated by insulating regions 9, that in the currently more advanced technologies are of STI (shallow trench isolation) type, i.e., they are constituted by trenches in the single crystalline silicon substrate 3, filled up by one or more dielectric layers.

Typically, the memory cells 100 are organized in a matrix structure, that, as shown by way of example in Figure 2 for a NOR matrix 200 of flash type memory cells 100, is arranged in rows 21, called word lines, running along the direction BB', and columns 22, called bit lines, running along the direction AA'.

In the matrix 200 the control gates 8 of the memory cells 100 form the word lines 21, and along this direction source connection lines 24, constituted by semiconductor material, extend in regular intervals, for example every 16 cells, running parallel to the bit lines 22.

The bit lines 22, that constitutes the drain connection lines, are formed by conductor material, typically a metal or an alloy of one or more metals (for example Al, AlCu, Cu, W...) and run perpendicularly to the word lines 21.

In the direction of the bit lines 22, the drains 2 of adjacent memory cells 100 face each other, and in correspondence of each pair of faced drains 2 drain electric contacts 23 are provided along the bit lines 22, connecting the drains 2 to the bit lines 22.

Also the sources 1 of adjacent memory cells 100 face each other in the direction of the bit lines 22, and the diffusion source lines 26 connect them to source connection lines 24 by means of source electric contacts 25, along the direction of the word lines 21.

A conventional process for the fabrication of flash memories calls for the formation of the insulation regions 9, for example of STI type, and of the floating gates 6 of the memory cells 100 through the following phases:

1. On the single crystalline silicon substrate 3, a sufficiently thin dielectric layer is grown, of thickness ranging from 10 to 20nm, called pad oxide;

2. On the pad oxide, a silicon nitride layer of thickness typically ranging from 100nm to 200nm is deposited, that has the function of stop layer for the following planarization treatments;

3. The areas where the STI type isolation regions 9 will be made are defined by lithography;

4. The nitride layer and the pad oxide are removed in sequence from these areas, and trenches of the desired depth, typically about 150nm, are formed inside of the single crystalline silicon bulk 3;

5. The trenches are filled with one or more layers of dielectric material, that as a whole are called field oxide;

6. The field oxide is planarized, typically using the CMP (chemical mechanical polishing) technique, in such a way as its exposed surface is flush with that of the still present nitride portion;

7. The exposed field oxide surface level is lowered, typically by a wet etch in hydrofluoric acid (HF), so that at the end of the process the height difference between the field oxide surface and the surface of the single crystalline silicon substrate 3 is not too high (~20nm).

After having formed in this way the STI type isolation regions 9, the process of formation of the floating gates 6 of the memory cells 100 proceeds with the following phases:

8. The portion of nitride still present is removed;

9. A sacrificial dielectric layer called sarox is grown, of thickness approximately equal to 10nm,;

10. Through the sarox layer, some phases of dopant implantation are performed, necessary to the operation of the memory cell 100;

11. The sarox layer and the pad oxide layer are removed by wet etching;

12. The tunnel oxide 5 is grown, of thickness ranging from 5nm to 10nm;

13. A polycrystalline silicon layer is deposited, of about 100nm thickness;

14. The polycrystalline silicon layer is defined by lithography and etching, so as to form the floating gate 6 of the memory cell 100;

15. The layer of ONO (oxide-nitride-oxide) 7 is deposited, covering the floating gate 6;

16. The control gate 8 is formed, typically made of heavily doped polycrystalline silicon.

In the last generation technologies the memory cells dimensions 100 are so small that the use of the traditional lithography for the definition of the floating gate 6 results critical. In fact, a possible misalignment, even minimum, in the lithographical definition phase (14) of the polycrystalline silicon layer, would result too high for so small geometries, and it would prevent from correctly defining the memory cell 100.

On the other hand, the request of reduction of the memory dimensions becomes more and more pressing with the technological progress, and this demand translates into the necessity of devising technological solutions and innovative integrated structures that allow combining in such devices an optimal electric behavior with minimal geometric dimensions.

Therefore, the possibility of making a floating gate self-aligned to the STI type isolation regions 9 has been investigated, by the deposition of the polycrystalline silicon layer immediately after the definition of the STI type isolation regions 9, and its subsequent planarization by CMP technique.

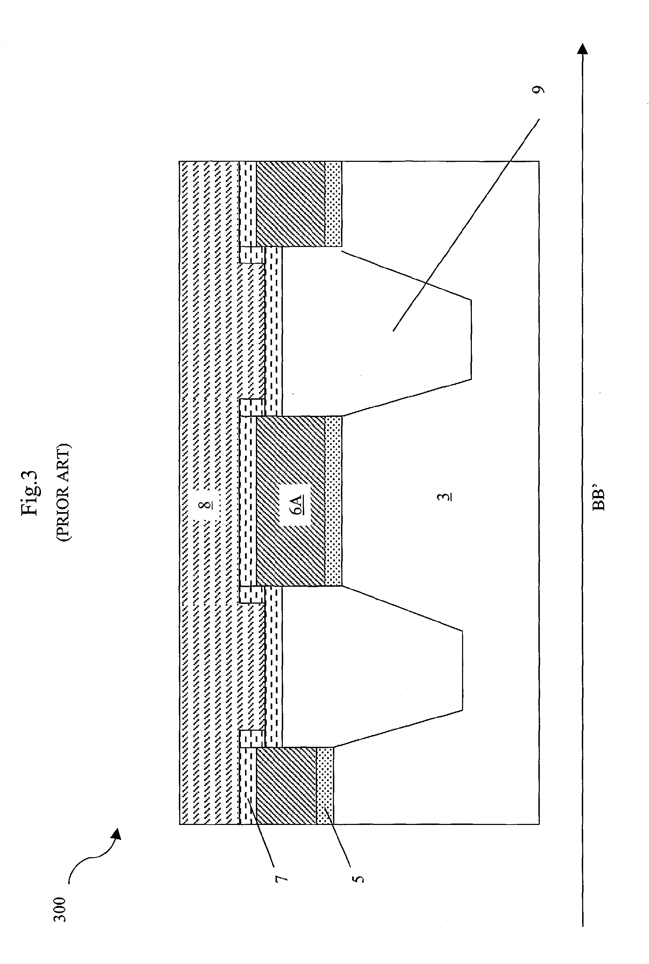

An example of flash memory cell 300 with floating gate 6A self-aligned to the STI type isolation regions is shown in Figure 3 in schematic transversal section along the direction BB', not in scale and limitedly to the layers of interest. Along the direction AA', the flash memory cell 300 has a structure similar to the memory cell 100 shown in Figure 1.

In detail, the solution with floating gate 6A self-aligned to the STI type isolation regions, similarly to the traditional process flow, provides for performing the phases of growth of the pad oxide layer (1), deposition of the silicon nitride layer (2), lithographical definition of the areas where the STI type isolation regions will be formed (3), removal in these areas of the silicon nitride and pad oxide layers and formation of trenches in the single crystalline silicon substrate 3 (4), filling of the trenches by the field oxide (5), and planarization by CMP technique of the field oxide (6).

At this point of the process flow, differently from the traditional process flow, the phase of lowering (7) of the exposed field oxide surface level is not performed.

Then, in a way similar to the traditional process flow, the phases of removal of the silicon nitride (8) still present, growth of the sarox layer (9), doping implantations necessary to the working of the memory cell 300 (10), removal of the sarox and pad oxide layers (11), and growth of the tunnel oxide 5 (12) are performed.

After the phase (12) of growth of the tunnel oxide 5, the solution with floating gate 6A self-aligned to the STI type isolation regions provides for the following process phases:

13A. A polycrystalline silicon layer is deposited, of thickness of about 200nm. The deposition of a thicker polycrystalline silicon layer compared to the traditional process flow is due to the necessity of having a layer to be planarized that is as uniform as possible;

114A. The polycrystalline silicon layer is planarized by CMP technique so that its exposed surface is flush with that of the field oxide;

14B. The exposed field oxide surface level is lowered, typically by a wet etching in hydrofluoric acid (HF), in such a way to uncover the side walls of the floating gate 6A.

Then, in a way similar to the traditional process flow, the phase of deposition (15) of the ONO layer 7 and the phase of formation (16) of the control gate 8 are performed.

Since in this way the floating gate 6A results automatically aligned to the STI type isolation regions 9, this process flow allows obtaining memory cells 300 of reduced dimensions compared to the memory cells 100 made by the traditional process flow.

Regretfully, for an equal thickness of deposited polycrystalline silicon layer, this last generation process flow produces floating gates 6A of such a morphology that strongly reduces the capacitive coupling coefficient $\alpha_G$ between floating gate 6A and control gate 8.

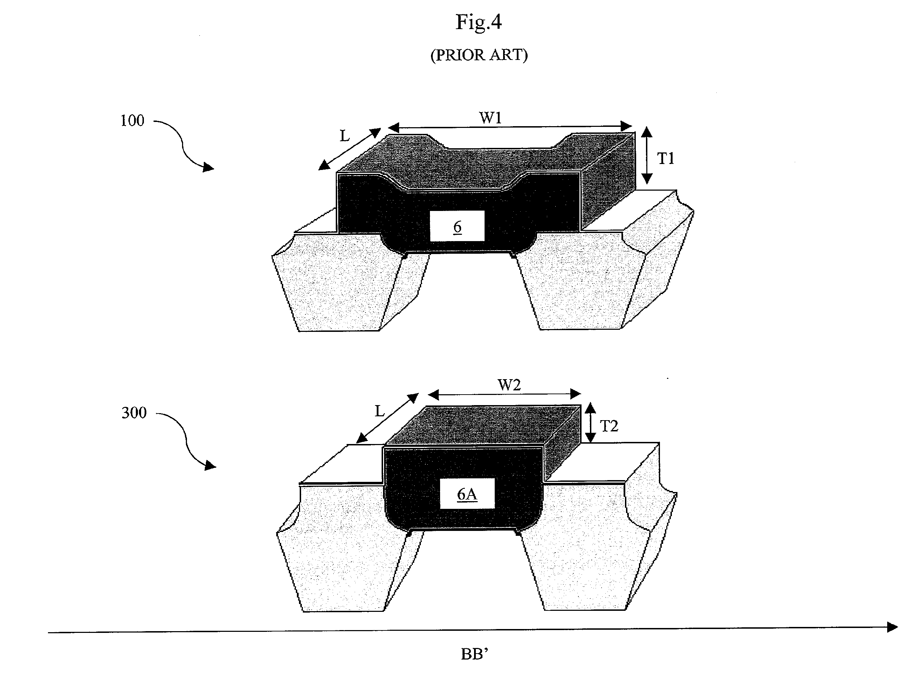

In fact, comparing the morphology of the traditional floating gate 6 of the memory cell 100 with that of the floating gate 6A of the memory cell 300, represented in Figure 4, it can be noticed that the traditional floating gate 6 has some protuberances, so-called "wings", that extend over the adjacent STI type isolation regions 9. Such wings are instead missing in the case of the floating gate 6A self-aligned to the STI type isolation regions 9 of the memory cell 300.

The lack of these "wings", due to the complex of the process phases that are used for the realization of the floating gate 6A, causes the width W2 of the floating gate 6A self-aligned to the STI type isolation regions 9 to be lower than the width W1 of the traditional floating gate 6.

Besides, also the effective thickness T2 of the floating gate 6A is lower than that of the traditional floating gate 6, indicated with T1.

This difference is due to the fact that in the process flow realizing the floating gate 6A self-aligned to the STI type isolation regions 9 the phase of lowering of the level of the exposed field oxide surface (14B) is performed after the growth phase (12) of the tunnel oxide 5. Therefore, a margin, of the order of the about ten nanometers, is required in the lowering phase (14B) of the exposed field oxide surface (14B) so as to guarantee the preservation of the tunnel oxide 5.

Accordingly, the side walls of the floating gate 6A are partially covered by field oxide, and therefore the effective thickness T2 of the floating gate 6A self-aligned to the STI type isolation regions 9 is lower than the effective thickness T1 of the traditional floating gate 6.

These differences in the geometric dimensions of the floating gate 6 and 6A reflect in the values of the capacitive coupling coefficients $\alpha_G$ of the traditional memory cell 100 and of the memory cell 300 with floating gate to the STI type isolation regions 9, whose ratio is expressed by the relationship:

$$\alpha_G(300)/\ \alpha_G(100) \div (W2+2T2)/(W1+2T1)$$

from which it can be deduced that, being W2 and T2 lower than W1 and T1, the capacitive coupling coefficient $\alpha_G$ (300) of the memory cell 300 with floating gate 6A self-aligned to the STI type isolation regions 9 is lower than the corresponding capacitive coupling coefficient $\alpha_G$ (100) of the traditional memory cell 100.

It has been verified experimentally that this difference can be estimated to be of order of 10% at least.

Such an efficiency loss in the capacitive coupling $\alpha_G$ leads to an increase in the erasing time of the memory cell 300 with floating gate 6A self-aligned to the STI type isolation regions 9, since the charge transfer process from the floating gate 6A to the source region 1 is less efficient, and makes it essential to reach a higher final erase voltage.

The management of high erase voltages is burdensome and can cause phenomenons of degradation of the quality of the active oxides, worsening the characteristics of reliability of the memory cell 300 with floating gate 6A self-aligned to the STI type isolation regions 9, whose electric performances result accordingly limited.

The formation of the floating gate 6A starting from a thicker deposited polycrystalline silicon allows partially recovering the loss of capacitive coupling between floating gate and control gate, but this introduces other problems; in particular, the filling by field oxide of the isolation trenches becomes critical because of the increased depth of the trench to be filled.

The technical problem that is at the base of the present invention, is therefore to devise a method for obtaining a floating gate non-volatile MOS memory device, that has very small geometric dimensions, and in which the memory cells have a capacitive coupling coefficient $\alpha_G$ between control gate and floating gate higher than that obtainable according to the state of the art, overcoming the limitations and the drawbacks that still limit the devices of this type made according to the prior art.

Such a technical problem is solved according to the invention by a method of making a floating gate non-volatile MOS semiconductor memory device as defined in claim 1, and with the preferred features defined in the following claims.

Another aspect of the invention concerns a floating gate non-volatile MOS semiconductor memory cell as defined in claim 17, and with the preferred features defined in the following claims.

The features and advantages of the proposed invention will result clear by the detailed description of some embodiments thereof that is done in the following, and by the drawings that accompany the text, where:

- In Figure 1 there is shown in schematic transversal section a flash memory cell according to the prior art, along two perpendicular directions AA' and BB';

- In Figure 2 a circuit diagram of a portion of a typical matrix structure of flash NOR memory cells according to the prior art is shown;

- In Figure 3 a flash memory cell with floating gate self-aligned to STI type isolation regions according to the prior art is shown, in schematic transversal section, along the direction BB';

- In Figure 4 there is shown in perspective view the comparison between the morphology of the transversal section of a flash memory cell with floating gate self-aligned to STI type isolation regions and that of a traditional memory cell, according to the prior art, along the direction BB';

- In Figure 5 there is shown, in schematic transversal section and limitedly to the layers of interest, a non-volatile MOS memory cell with floating gate self-aligned to STI type isolation regions according to an embodiment of the invention, along the direction BB';

- Figures 6A-6E show, in transversal section along the direction BB' and in schematic way, some process phases for making STI type isolation regions and tunnel oxide, according to an embodiment of the invention;

- Figures 7A-7E depict, in transversal section along the direction BB', and in schematic way, some phases of a method of making a non-volatile MOS memory device with floating gate self-aligned to STI type isolation regions according to a first embodiment of the invention;

- Figures 8A-8C show, in transversal section along the direction BB' and in schematic way, a sequence of phases of a method of making non-volatile MOS memory device with floating gate self-aligned to STI type isolation regions according to a second embodiment of the invention;

- The Figures 9A-9F represent, in transversal section along the direction BB' and in schematic way, a sequence of phases of a method of making a non-volatile MOS memory device with floating gate self-aligned to STI type isolation regions according to a third embodiment of the invention.

A method of making a non-volatile MOS memory device with floating gate self-aligned to STI type isolation regions according to an embodiment of the invention will be now described.

Particularly, the case of a flash type non-volatile MOS memory device with floating gate self-aligned to STI isolation regions is considered by way of example.

The example does not constitute a limitation of the present invention, that can be applied also to different types of non-volatile MOS memory devices with floating gate self-aligned to STI isolation regions.

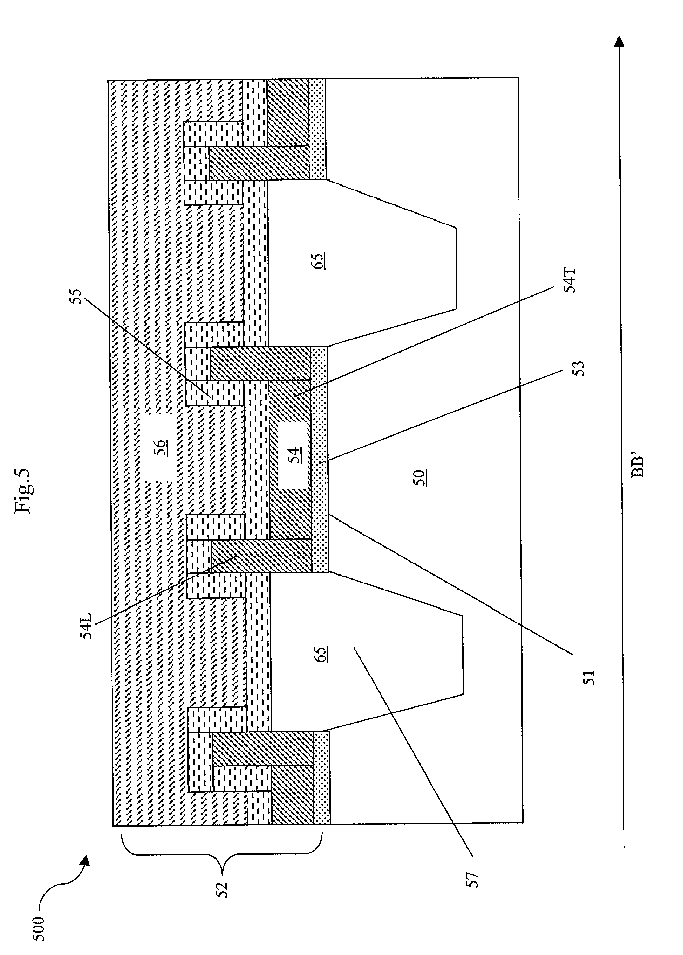

With reference to Figure 5, an example of flash type memory cell 500 inside a non-volatile MOS memory device, obtained according to an embodiment of the invention, is represented in schematic transversal section and limitedly to the layers of interest along the direction BB', and includes an electrically active region 51 inside a single crystalline silicon substrate 50, surmounted by a layer structure that constitutes the gate electrode region 52.

The gate electrode region 52 includes:

- a first, thin dielectric layer 53, typically silicon oxide, called tunnel oxide;

- the floating gate 54, including a first conductor material layer, for example heavily doped polycrystalline silicon;

- a second dielectric layer 55, for example constituted by a $SiO_2/Si_3N_4/SiO_2$ layers sequence called ONO (oxide-nitride-oxide), that covers the floating gate 54;

- the control gate 56, formed by a second conductor material layer, for example heavily doped polycrystalline silicon.

Along the direction BB', direction along which the word lines extend, adjacent memory cells 500 are separated by STI (shallow trench isolation) type isolation regions 57.

According to an embodiment of the invention, the floating gate 54 advantageously takes a concave, generically saddle form. Particularly, the floating gate 54 includes a base wall 54T and side walls 54L, of shape and thickness such as to cause the floating gate 54 exhibit a concavity facing upward that makes the floating gate take a generically "U" shape. Besides, the floating gate 54 advantageously includes a conformal material conductor layer, that is such as to substantially follow the profile of the underlying layers. These characteristics of the floating gate 54 allow obtaining a gate capacitive coupling $\alpha_G$ of the memory cell 500 higher compared to the prior art and they favor a reduction of the reading disturbs associated with the capacitive couplings between the floating gates 54 of adjacent memory cells 500.

Particularly, according to a preferred embodiment of the invention, said side walls 54L protrude from said base wall 54T of a height equal to at least 5 times the thickness of said base wall 54T.

The structure just described can be obtained according to an embodiment of the invention by the process flow that is described in the following, that is limited to the description of the process phases of interest for the understanding of the method according to the invention, and is not exhaustive of a process flow suitable to obtain an integrated memory device according to well known techniques.

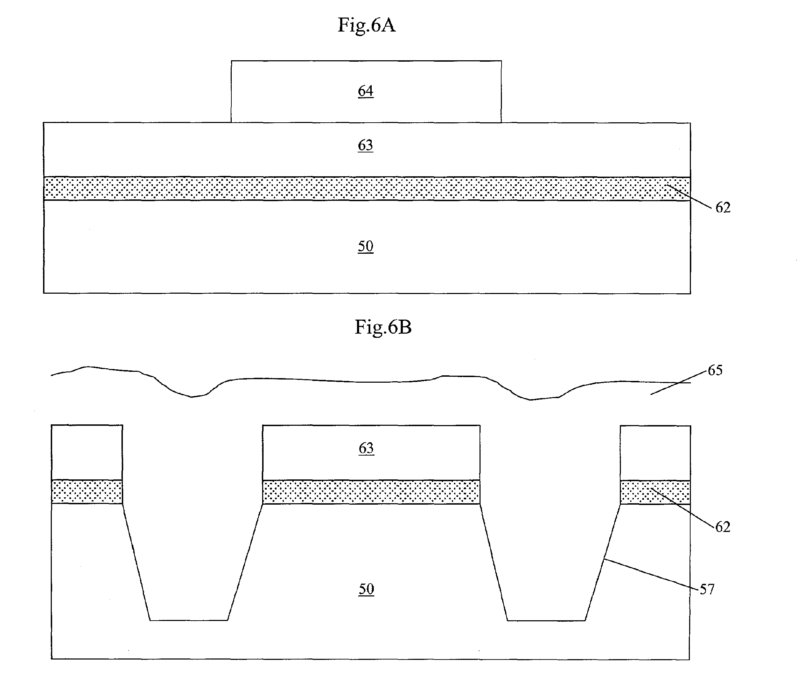

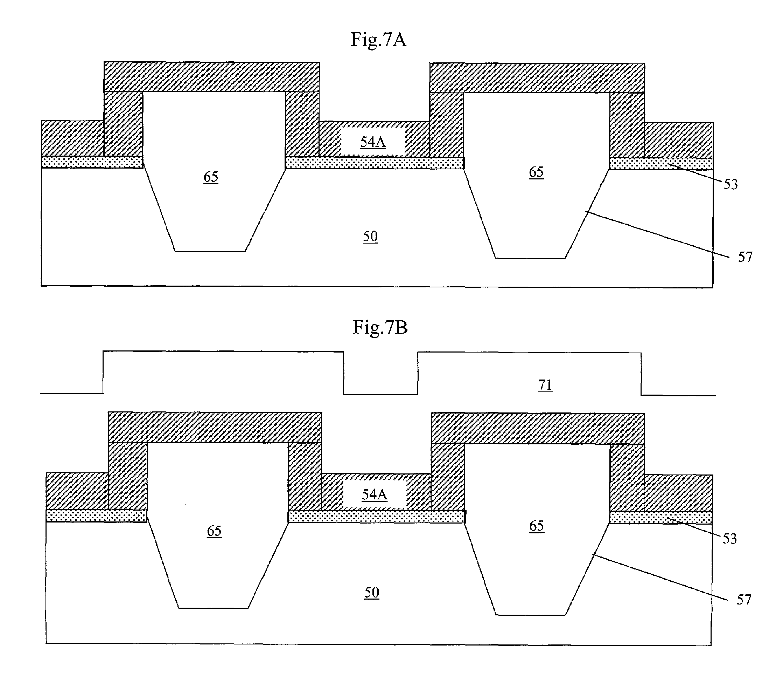

With reference to Figures 6A-6E and 7A-7E, an embodiment of the proposed innovative solution includes the following process phases for the formation of the STI isolation regions 57 and of the floating gates 54 self-aligned to the STI isolation regions 57:

1. A sufficiently thin dielectric layer 62 called pad oxide is grown on the single crystalline silicon substrate 50, preferably of thickness ranging from 10 to 20nm, (Figure 6A);

2. On the pad oxide 62, a silicon nitride layer 63 of thickness ranging typically from 100nm to 200nm is deposited, that has the function of stop layer for the following treatments of planarization (Figure 6A);

3. The areas where the STI isolation regions 57 will be made are defined, for example by lithography with photosensitive material 64 (Figure 6A);

4. From these areas, the silicon nitride layer 63 and the pad oxide 62 are removed in sequence, for example by an anisotropic dry etch. Simultaneously, trenches of desired depth are formed in the single crystalline silicon substrate 50, for example of the order of 150nm (Figure 6B);

5. The trenches are filled with one or more layers of dielectric material, that in their complex take the name of field oxide 65 (Figure 6B);

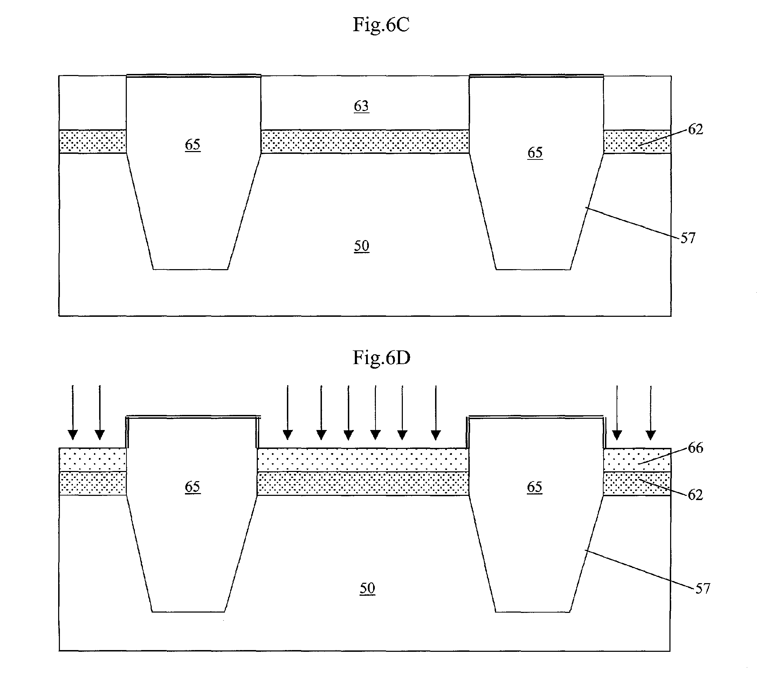

6. The field oxide 65 is planarized, using for example the CMP (chemical mechanical polishing) technique, so that its exposed surface is flush with that of the still present silicon nitride portion 63 (Figure 6C).
After having formed in this way the STI isolation regions 57, the process of formation of the floating gates 54 self-aligned to the STI isolation regions 57 proceeds with the following phases:

7. The portion of silicon nitride 63 still present is removed (Figure 6D);

8. A sacrificial dielectric layer 66 called sarox is grown, preferably of thickness of about 10nm. Through the sarox layer 66, some phases of implantation of dopants necessary to the memory cell 500 operation (Figure 6D) can be performed;

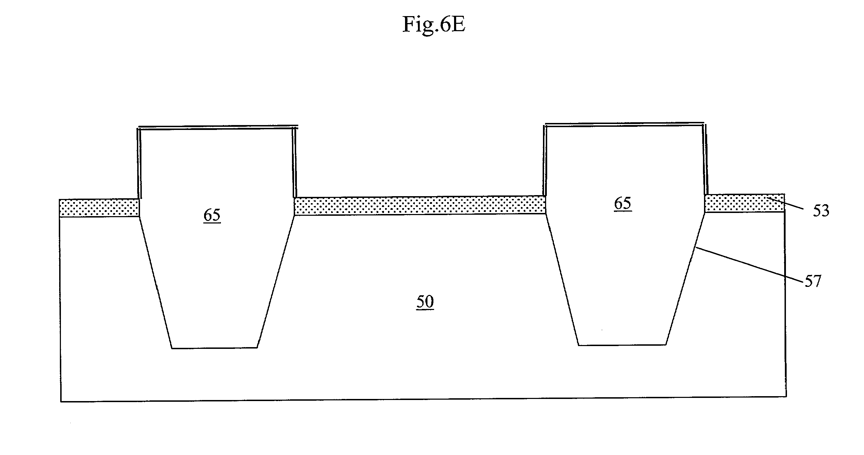

9. The sarox layer 66 and the pad oxide 62 layer are removed, for example by a wet etching (Figure 6E);

10. The tunnel oxide 53 is grown, preferably of thickness ranging from 5nm to 10nm (Figure 6E).
After the phase (10) of tunnel oxide growth 53, a first embodiment of the invention advantageously proposes the following process phases, shown in Figures 7A-7E:

11. A conductor material layer 54A is deposited, for example heavily doped polycrystalline silicon, of thickness such as to result conformal (Figure 7A). This characteristic of the conductor material layer 54A, in combination with the presence of underlying layers of suitable profile, advantageously causes it to take, inside the electrically active regions 51, the concave, saddle shape previously defined. The layer 54A of conformal conductor material forms the floating gate 54 of the memory cell 500, and for example has a thickness ranging from 1nm to 70nm, preferably 10nm;

12. A dielectric layer 71 is deposited, for example silicon oxide, of thickness ranging from 100nm to 1000nm, preferably ranging from 500nm to 600nm, that fills the concavity of the conductor material layer 54A (Figure 7B);

13. The dielectric layer 71 and the conformal conductor material layer 54A are planarized, for example by CMP (chemical mechanical polishing) technique, up to uncovering the field oxide surface 65, so as to remove the portion of the conductor material layer 54A that is above the field oxide 65 (Figure 7C). In this way the formation of the floating gate 54 is completed, the floating gate advantageously has the concave saddle shape defined above, with base wall 54T and side walls 54L;

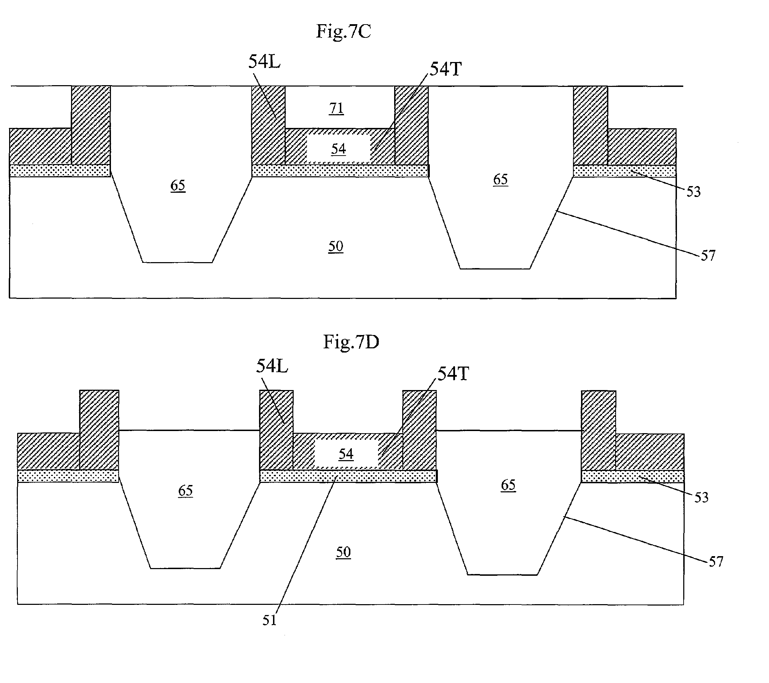

14. The dielectric layer 71 is removed, for example by a wet etching, for example in hydrofluoric acid (HF). Advantageously, during such etch the level of the exposed field oxide surface 65 is lowered too, in such a way to uncover the side walls 54L of the floating gate 54 (Figure 7D);

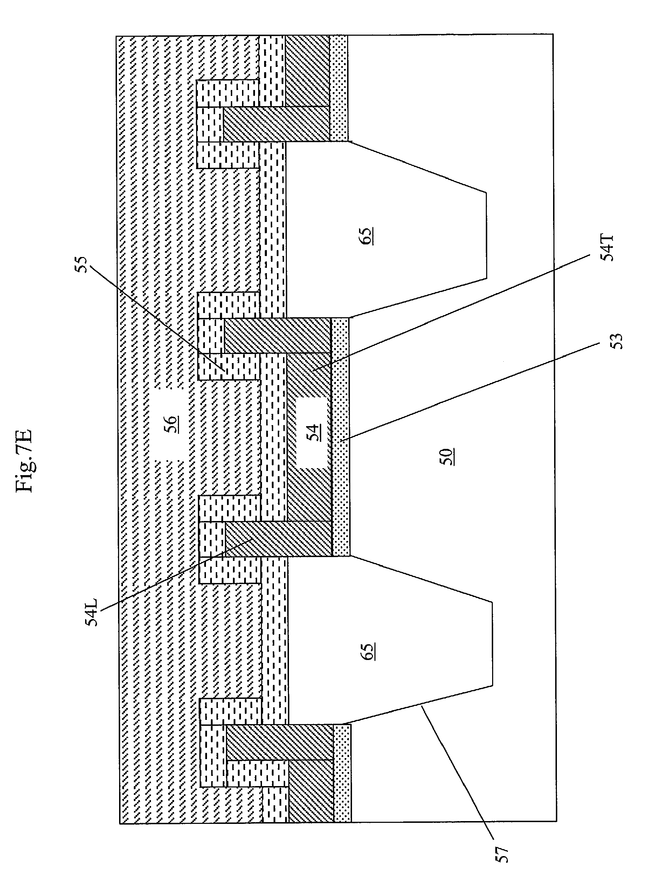

15. The dielectric layer 55, for example ONO (oxide-nitride-oxide), is deposited, covering the floating gate 54 (Figure 7E);

16. The control gate 56 is formed, made for example of heavily doped polycrystalline silicon (Figure 7E).

The process continues from now on according to a traditional scheme, with an anisotropic etch of the control gate 56, ONO 55 and floating gate 54 layer sequence, followed by the complex of known operations that lead to the finished memory device.

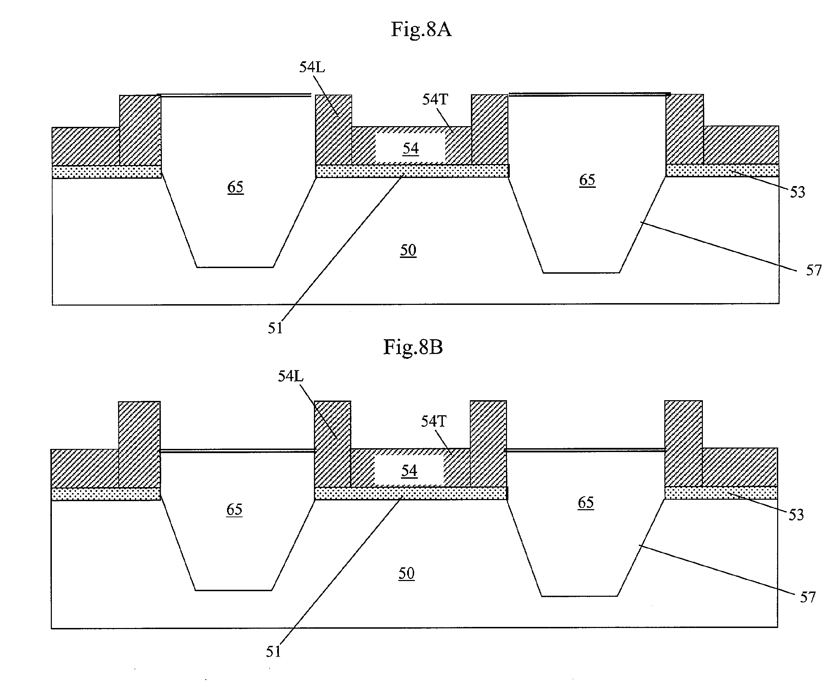

An alternative to the sequence of process phases just described, according to a second embodiment of the invention, consists in replacing the deposition phase (12) of the dielectric layer 71, the phase (13) of planarization of the dielectric layer 71 and of the conformal conductor material layer 54A, and the removal phase (14) of the dielectric layer 71 from the concavity of the floating gate 54, and simultaneous lowering of the level of the exposed field oxide surface 65, with the following process phases, shown in Figures 8A-8C:

12A. The portion of the conductor material layer 54A above the field oxide 65 is removed, for example by CMP (chemical mechanical polishing) technique, so as to leave the conductor material layer 54A only inside the electrically active regions 51 (Figure 8A). In this way, the formation of the floating gate 54 is completed; the floating gate advantageously has the concave saddle, shape previously defined, with base wall 54T and side walls 54L;

13A. The level of the exposed field oxide surface 65 is lowered, by a wet etching, for example in hydrofluoric acid (HF), in such a way to uncover the side walls 54L of the floating gate 54 (Figure 8B);

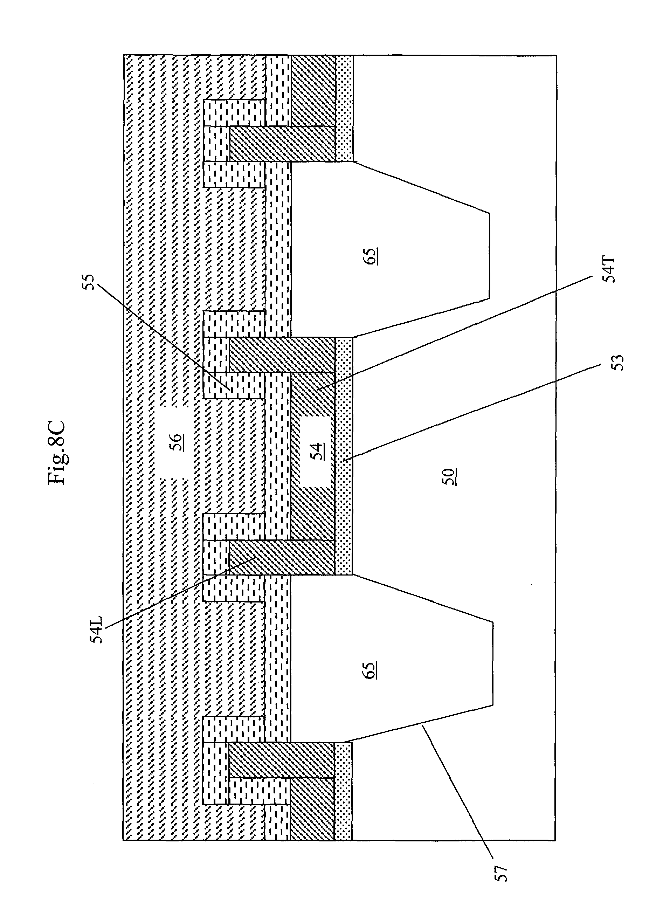

14A. The dielectric layer 55, for example ONO (oxide-nitride-oxide), is deposited, covering the floating gate 54 (Figure 8C);

15A. The control gate 56 is formed, made for example of heavily doped polycrystalline silicon (Figure 8C).

From now on, the process proceeds in conventional way, by the anisotropic etch of the control gate 56, ONO 55 and floating gate 54 sequence of layers, and following operations.

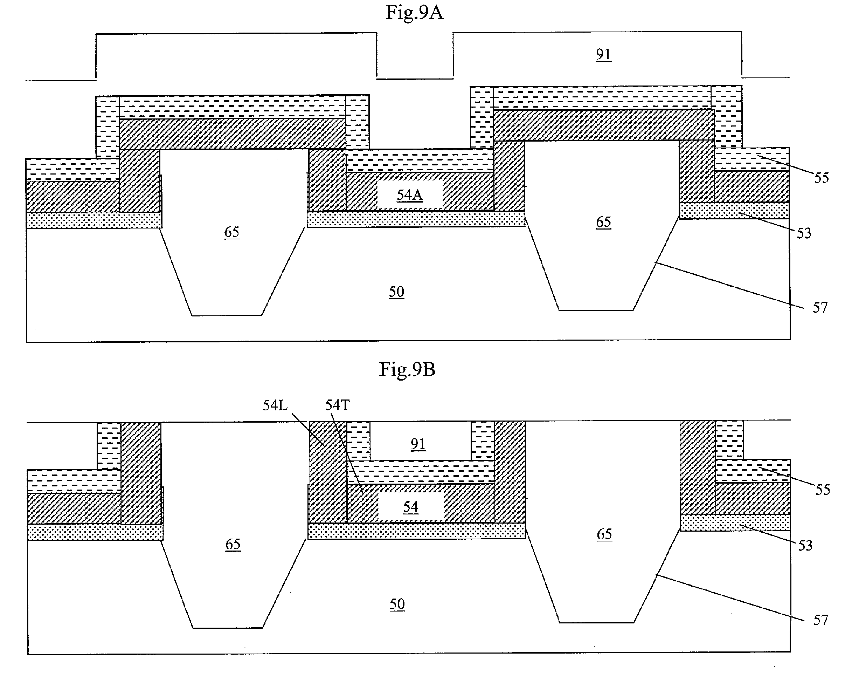

A third embodiment of the invention proposes instead, after the deposition phase (11) of the conformal conductor material layer 54A, the following process phases, shown in Figures 9A-9F:

12B. The dielectric layer 55, for example ONO (oxide-nitride-oxide), is deposited (Figure 9A);

13B. The concavity of the conductor material layer 54A is filled by the deposition of a conductor material layer 91, for example a metallic alloy such as TiN (titanium nitride) or SiTiN, having an oxidation rate lower than the conductor material layer 54A, for example polycrystalline silicon (Figure 9A). The thickness of the conductor material layer 91 ranges from 100nm to 1000nm, preferably from 500nm to 600nm;

14B. The layers of conductor material 91, ONO 55 and conductor material 54A are planarized, for example by CMP (chemical mechanical polishing) technique, up to uncover the field oxide surface 65, so as to remove the portion of the conductor material layer 54A that is above the field oxide 65 (Figure 9B). In this way the formation of the floating gate 54 is completed, that advantageously has the concave, saddle shape defined above, with base wall 54T and side walls 54L;

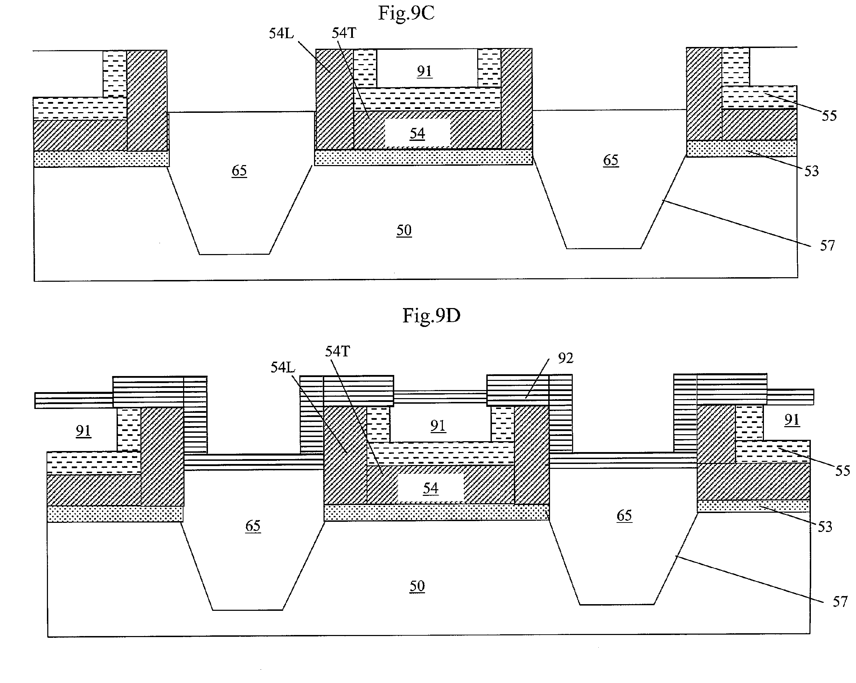

15B. The level of the exposed field oxide surface 65 is lowered, in such a way to uncover the side walls 54L of the floating gate 54 (Figure 9C);

16B. A thin oxide layer 92 is grown by means of an oxidation, preferably of thickness equivalent to that of the ONO layer 55, or for example ranging from 5nm to 50nm, preferably ranging from 10nm to 15nm (Figure 9D). In this way, the conductor material layer 91 is laterally isolated from the surrounding. Besides, since the conductor material layer 91 has an oxidation rate lower than the conductor material of the floating gate 54, on the exposed surface of the floating gate 54 an oxide 92 grows of thickness greater than that of the oxide grown on the exposed surface of the conductor material layer 91;

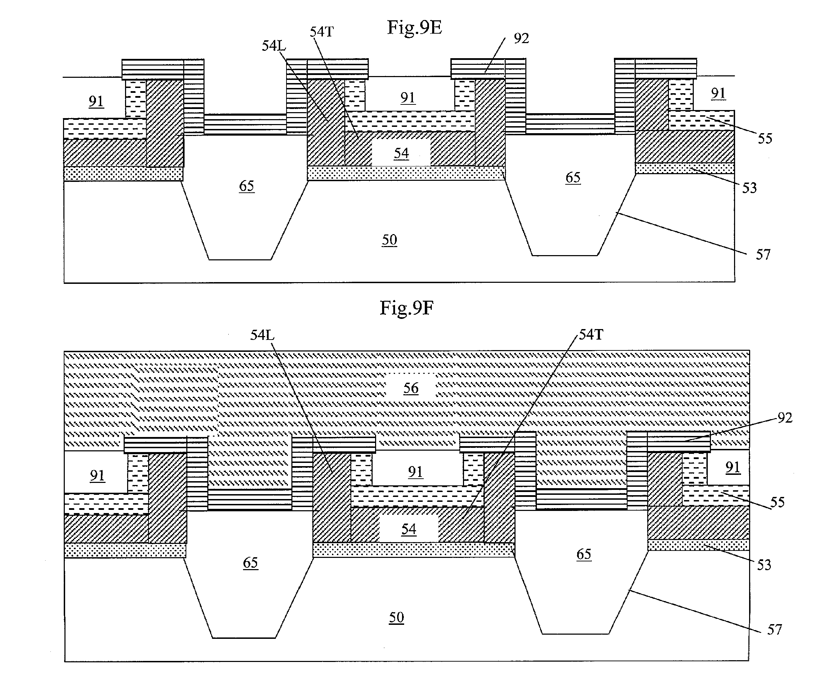

17B. An oxide-removal operation is performed that removes the oxide portion 92 grown on the conductor material layer 91 during the oxidation phase 17B (Figure 9E). For the reasons explained at the point 16B, such oxide-removal operation does not remove completely the oxide portion 92 grown on the floating gate 54, thus guaranteeing the electric isolation thereof from the surrounding;

18B. The control gate 56 is formed, made for example of heavily doped polycrystalline silicon (Figure 9F).

From now on, the process proceeds following a known process scheme that brings to the finished memory device.

By the method just described, thanks to the invention it is possible to make a floating gate non-volatile semiconductor memory device of very reduced geometric dimensions, typical of memory devices with floating gate self-aligned to STI isolation regions, in which nevertheless the memory cells advantageously possess a capacitive coupling coefficient $\alpha_G$ higher than that obtainable by the prior art, overcoming the limitations and the drawbacks that limit the known devices of this type.

In fact, thanks to the method according to the invention, and particularly to the floating gate shape, the portion of floating gate surface that faces the control gate is greater than that obtainable according the prior art.

Accordingly, being the capacitive coupling coefficient $\alpha_G$ directly proportional to the area of the floating gate surface facing the control gate, its value, thanks to the method according to the invention, is greater than that obtainable by known methods.

Such a higher value of the capacitive coupling coefficient $\alpha_G$ significantly improves the efficiency of the programming and erasing operations of the memory cells, thus overcoming the problems present in memory devices made according to the known principles.

Advantageously, the method according to the invention allows obtaining a higher value of the capacitive coupling coefficient $\alpha_G$ without the addition of lithographic phases, that can produce misalignments and dimensional problems.

Besides, the method according to the invention allows making a floating gate non-volatile semiconductor memory device in which the parasitic capacitive coupling between adjacent memory cells advantageously results reduced in comparison to that obtainable according to the prior art.

This important advantage is due to the fact that, operating in the way proposed by the invention, the floating gate that is obtained, thanks to the peculiar concave, saddle shape, possesses side walls of lower area than the devices made according to the prior art.

In fact, based on the model of a capacitor with plane and parallel plates, the parasitic capacitive coupling between adjacent memory cells, particularly in the direction AA' along which the bit lines extend, is directly proportional to the area of the walls of the floating gates of adjacent cells facing each other.

Since according to the method of the invention it is advantageously the thickness of a deposited layer, and not a lithography operation, that defines the thinness of the side walls of the floating gate, the invention allows making the side walls of floating gates of adjacent memory cells of very reduced thickness, if desired thinner than the base wall, thereby allowing to make adjacent memory cells with reduced parasitic capacitive coupling.

This peculiarity is particularly advantageous in the case the method according to the invention is applied to NAND flash type floating gate non-volatile semiconductor memory devices, in which the disturbs due to the parasitic capacitive coupling between adjacent memory cells currently represent one of the causes of variation of the threshold voltage in the memory cell matrixes.

Besides, it is particularly useful applying the method according to the invention devices to multilevel flash memory, in which the reduced threshold variation margins between the different programming states make the correct operation of the memory cells particularly critical in the presence of a high parasitic capacitive coupling between adjacent memory cells.

The method according to the invention is therefore very advantageous in the case of NOR or NAND flash type or multilevel floating gate non-volatile semiconductor memory devices, but it can be applied to any semiconductor memory device in which it is necessary to have a wide coupling area between the floating gate and any other electrode.

**Claims**

1. Method of making a non-volatile MOS semiconductor memory device including a phase of formation, in a semiconductor material substrate (50), of STI (shallow trench isolation) isolation regions (57) filled by field oxide (65) and of memory cells (500) separated one from the other by said STI isolation regions (57), said memory cells (500) including a gate electrode (52) electrically insulated from said substrate (50) of semiconductor material by a first dielectric layer (53), said gate electrode (52) including a floating gate (54) self-aligned to said STI isolation regions (57), **characterized by** comprising a phase of formation of said floating gate (54) exhibiting substantially a saddle shape including a concavity, said formation phase of said floating gate (54) including a deposition phase of a first conformal conductor material layer (54A).

2. Method according to claim 1, **characterized in that** said formation phase of said floating gate (54) includes the formation of a base wall (54T) and of side walls (54L) belonging to said floating gate (54), said side walls (54L) protruding from said base wall (54T) in proximity of said STI isolation regions (57).

3. Method according to claim 2, **characterized by** comprising, subsequently to said deposition phase of said first conformal conductor material layer (54A):

   - a deposition phase of a first dielectric layer (71) on said first conformal conductor material layer (54A);
   - a first removal phase of said first dielectric layer (71) and of said first conformal conductor material layer (54A) from the top of said STI isolation regions (57) so as to form said substantially saddle shape of said floating gate (54);
   - a second removal phase of said first dielectric layer (71) and simultaneous lowering of the level of the exposed surface of said field oxide (65), to uncover said side walls (54L) of said floating gate (54).

4. Method according to claim 3, **characterized in that** said first dielectric layer (71) includes silicon oxide.

5. Method according to claim 3, **characterized in that** said first removal phase includes a planarization phase, particularly by CMP (chemical mechanical polishing).

6. Method according to claim 3, **characterized in that** said second removal phase includes a wet etching, particularly in presence of hydrofluoric acid (HF).

7. Method according to claim 2, **characterized in that** said deposition phase of said first conformal conductor material layer (54A) is followed by the following phases:

   - a removal phase of said first conformal conductor material layer (54A) from the top of said STI isolation regions (57) so as to form said floating gate (54);
   - a phase of lowering of the exposed surface of said field oxide (65) to uncover said side walls (54L) of said floating gate (54).

8. Method according to claim 7, **characterized in that** said removal phase includes a phase of planarization, particularly by CMP (chemical mechanical polishing).

9. Method according to any one of claims from 2 to 8, **characterized by** further comprising a formation phase of a control gate (56) electrically insulated from said floating gate (54) by a second dielectric layer (55).

10. Method according to claim 2, **characterized by** comprising, after said deposition phase of said first conformal conductor material layer (54A):

    - a deposition phase of a second dielectric layer (55);
    - a deposition phase of a second conductor material layer (91);
    - a first removal phase of said conductor material layer (91), of said second dielectric layer (55) and of said first conformal conductor material layer (54A) from the top of said STI isolation regions (57) so as to form said floating gate (54);
    - a lowering phase of the exposed surface of said field oxide (65) to uncover said side walls (54L) of said floating gate (54);
    - a formation phase of a third dielectric layer (92) for laterally insulating said second conductor material layer (91);
    - a second removal phase of said third dielectric layer (92) from the top of said second conductor material layer (91);
    - a formation phase of a control gate (56) electrically insulated from said floating gate (54) by said second dielectric layer (55).

**11.** Method according to claim 10, **characterized in that** said formation phase of said third dielectric layer (92) includes an oxidation phase, and said second conductor material layer (91) includes a material having an oxidation rate lower than said first conformal conductor material layer (54A).

**12.** Method according to claim 10, **characterized in that** said second conductor material layer (91) includes a metal alloy, particularly titanium nitride (TiN) or SiTiN.

**13.** Method according to claim 10, **characterized in that** said first removal phase includes a planarization phase, particularly by CMP (chemical mechanical polishing).

**14.** Method according to claim 7 or 10, **characterized in that** said phase of lowering includes a wet etching, particularly in presence of hydrofluoric acid (HF).

**15.** Method according to any one of the preceding claims, **characterized in that** said first conformal conductor material layer (54A) includes doped or non doped polycrystalline silicon.

**16.** Method according to any one of the preceding claims, **characterized in that** said first conformal conductor material layer (54A) has a thickness ranging from 1nm to 70nm, preferably 10nm.

**17.** Non-volatile MOS semiconductor memory cell (500) formed inside a semiconductor material substrate (50) including STI isolation regions (57) used to electrically insulate said memory cell (500), said memory cell (500) including a gate electrode (52) electrically insulated from said semiconductor material substrate (50) by a first dielectric layer (53), the gate electrode (52) including a floating gate (54) self-aligned to said STI isolation regions (57), **characterized in that** said floating gate (54) includes a conformal conductor material layer (54A) and has a substantially saddle shape including a concavity.

**18.** Memory cell (500) according to claim 17, **characterized in that** said floating gate (54) includes a base wall (54T) and side walls (54L) projecting from said base wall (54T) in proximity of said STI isolation regions (57).

**19.** Memory cell (500) according to claim 18, **characterized in that** said base wall (54T) has a thickness ranging from 1nm to 70nm, preferably 10nm.

**20.** Memory cell (500) according to claim 18 or 19, **characterized in that** said side walls (54L) project from said base wall (54T) of a height equal to at least 5 times the thickness of said base wall (54T).

**21.** Memory cell (500) according to claim 18, **characterized in that** said conformal conductor material layer (54A) includes doped or undoped polycrystalline silicon.

**22.** Memory cell (500) according to claim 18, **characterized in that** said gate electrode (52) further includes a control gate (56) electrically insulated from said floating gate (54) by a second dielectric layer (55).

**23.** A flash EEPROM type memory cell (500) according to claim 18.

**24.** Semiconductor memory device **characterized by** comprising memory cells (500) according to claim 18, arranged according to at least one between a NOR architecture and a NAND architecture.

## Fig.1

(PRIOR ART)

100

4 { 8 7 6 5 1 2 3 10

AA'

8 7 6 5 3 9

BB'

EP 1 675 181 A1

12

Fig.2
(PRIOR ART)

# Fig.3

300

8

7

6A

5

3

9

BB'

EP 1 675 181 A1

14

Fig.4
(PRIOR ART)

## Fig.5

EP 1 675 181 A1

Fig.6A

Fig.6B

Fig.6C

Fig.6D

Fig.6E

EP 1 675 181 A1

Fig.7A

53
57
65
54A
50

Fig.7B

53
57
71
65
54A
50

Fig.7C

54L 54T

71

54

50

65

65

53

57

Fig.7D

54L 54T

54

50

65

65

53

57

51

Fig.7E

55
56
54L
65
65
54
50
57
53
54T

EP 1 675 181 A1

Fig.8A

54L

54T

54

65

65

53

50

57

51

Fig.8B

54L

54T

54

65

65

53

50

57

51

# Fig.8C

EP 1 675 181 A1

## Fig.9A

91

55

54A

65          65

53

50

57

## Fig.9B

54L    54T

91

55

54

65          65

53

50

57

## Fig.9C

54L 54T

91

54

65 65

50

55

53

57

## Fig.9D

54T 92

54L

91 91 91

54

65 65

50

55

53

57

Fig.9E

54T

54L          92

91          91          91

55

54

65          65          53

50          57

Fig.9F

54L          54T

56

92

91          91          91

55

54

65          65          53

50          57

**European Patent Office**

**EUROPEAN SEARCH REPORT**

Application Number

EP 04 42 5937

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 00/51188 A (CHEN, CHIOU-FENG) 31 August 2000 (2000-08-31) | 1-5,7-9, 15-24 | H01L27/115 H01L21/8247 H01L21/28 H01L29/423 |
| Y | * the whole document * | 6,10-14 | |
| X | US 6 153 472 A (DING ET AL) 28 November 2000 (2000-11-28) | 1,7,9, 13,17, 18,21-24 | |
| Y | * the whole document * | 10-14 | |
| A | | 2-6,8, 15,16, 19,20 | |
| Y | US 5 915 177 A (TSENG ET AL) 22 June 1999 (1999-06-22) | 6,14 | |
| A | * column 3, line 10 - column 4, line 51; figures 1-7 * | 1-5, 7-13, 15-24 | |
| Y | US 5 739 566 A (OTA ET AL) 14 April 1998 (1998-04-14) | 12 | |
| A | * column 5, line 59 - line 62; figure 5 * | 1 | TECHNICAL FIELDS SEARCHED (Int.Cl.7) |
| X | US 2002/195646 A1 (TSENG HORNG-HUEI) 26 December 2002 (2002-12-26) | 1,2,9, 15-24 | H01L |
| A | * paragraph [0017] - paragraph [0022]; figures 1-5 * | 3-8, 10-14 | |

The present search report has been drawn up for all claims

| Place of search | Date of completion of the search | Examiner |
|---|---|---|
| The Hague | 19 May 2005 | Albrecht, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 04 42 5937

This annex lists the patent family members relating to the patent documents cited in the above-mentioned European search report.
The members are as contained in the European Patent Office EDP file on
The European Patent Office is in no way liable for these particulars which are merely given for the purpose of information.

19-05-2005

| Patent document cited in search report | | Publication date | Patent family member(s) | | Publication date |
|---|---|---|---|---|---|
| WO 0051188 | A | 31-08-2000 | US 6140182 A | | 31-10-2000 |
| | | | US 6091104 A | | 18-07-2000 |
| | | | CN 1300444 A | | 20-06-2001 |
| | | | EP 1076916 A1 | | 21-02-2001 |
| | | | JP 2002538608 A | | 12-11-2002 |
| | | | TW 439280 B | | 07-06-2001 |
| | | | WO 0051188 A1 | | 31-08-2000 |
| | | | US 6291297 B1 | | 18-09-2001 |
| US 6153472 | A | 28-11-2000 | TW 490860 B | | 11-06-2002 |
| US 5915177 | A | 22-06-1999 | NONE | | |
| US 5739566 | A | 14-04-1998 | JP 2663887 B2 | | 15-10-1997 |
| | | | JP 8153811 A | | 11-06-1996 |
| US 2002195646 | A1 | 26-12-2002 | NONE | | |

EPO FORM P0459

For more details about this annex : see Official Journal of the European Patent Office, No. 12/82